# EUROPÄISCHE PATENTSCHRIFT

(11) **EP 3 689 543 B1**
(45) Veröffentlichungstag und Bekanntmachung des Hinweises auf die Patenterteilung: **21.09.2022**
(21) Anmeldenummer: 19154471.7
(22) Anmeldetag: 30.01.2019
(51) Int. Cl.: B24B 13/005, C23C 14/50, C23C 16/458, B29D 11/00

(54) **VORRICHTUNG UND VERFAHREN ZUR EINBRINGUNG EINER OPTISCHEN LINSE IN EINE WENDEEINRICHTUNG**
DEVICE AND METHOD FOR INSERTING AN OPTICAL LENS INTO A TURNING DEVICE
DISPOSITIF ET PROCÉDÉ D'APPLICATION D'UNE LENTILLE OPTIQUE DANS UN DISPOSITIF DE RETOURNEMENT

(43) Veröffentlichungstag der Anmeldung: 05.08.2020
(73) Patentinhaber: Carl Zeiss Vision International GmbH, 73430 Aalen (DE)
(72) Erfinder: Macionczyk, Frank, 73447 Oberkochen (DE)
(74) Vertreter: Altmann Stößel Dick Patentanwälte PartG mbB

(56) Entgegenhaltungen:
- EP-A1- 0 406 484
- DE-A1- 1 652 019
- DE-A1-102006 041 137

## Beschreibung

### Gebiet der Erfindung

Die vorliegende Erfindung betrifft eine Wendeeinrichtung und eine damit räumlich fixierte Vorrichtung sowie ein Verfahren zur Einbringung einer optischen Linse, bevorzugt eines Brillenglases, in eine Wendeeinrichtung. Die Vorrichtung und das Verfahren können hierbei insbesondere für eine möglichst kraft- und reibungsarme Einbringung des Brillenglases in die Wendeeinrichtung eingerichtet sein, insbesondere für die Einbringung des Brillenglases in die Wendeeinrichtung zu einer beiderseitigen Beschichtung des Brillenglases in einer Vakuumbeschichtungsanlage.

### Stand der Technik

Aus dem Stand der Technik sind Vorrichtungen und Verfahren zur Einbringung von optischen Linsen, vorzugsweise von Brillengläsern, in eine Wendeeinrichtung bekannt. Insbesondere in der industriellen Fertigung von Brillengläsern kommen derartige Vorrichtungen und Verfahren seit längerem zum Einsatz.

EP 0 215 261A2 offenbart eine Halterung für ein Brillenglas in Form eines elastisch verformbaren Ringes, welcher an seiner Innenseite Gabeln zur Aufnahme des zu haltenden Brillenglases aufweist.

DE 101 46 542 A1 und EP 1 295 962 A1 offenbaren jeweils ein Verfahren zum maschinellen Handhaben eines Brillenglases, wobei das Brillenglas für die Dauer der Handhabung in einer Halterung festgelegt und der Verbund aus der Halterung und dem Brillenglas durch wenigstens einen Handhabungs- oder Verfahrensschritt geführt wird. Hierzu wird eine Halterung vorgeschlagen, welche Haltemittel für das Brillenglas in einer Aufnahmeöffnung aufweist, wobei die Haltemittel von einem Klemmabschnitt der Halterung selbst gebildet oder als Federelement ausgestaltet sind.

DE 10 2004 026 523 A1 offenbart einen Wechselrahmen zur Aufnahme einer Optikkomponente mit einem plattenförmigen Grundkörper, der über einen Durchbruch, der eine der aufzunehmenden Optikkomponente entsprechende Form aufweist, verfügt. Weiterhin verfügt der Wechselrahmen über Ausklinkungen in dem Grundkörper, welche sich ausgehend von dem Durchbruch erstrecken und für ein berührungsloses Eintauchen von am Randbereich der Optikkomponente anstehenden Halteelementen und/oder Klemmelementen bei einer Handhabung der Optikkomponente vorgesehen sind.

EP 0 406 484 A1 offenbart eine Linsenhalterung, insbesondere für in einer Sputteranlage zu beschichtende Brillenglaslinsen, welche im Wesentlichen als ein die zu haltende Linse tragender Ring ausgebildet ist, der seinerseits mit einer Substrathalterung verbindbar ist, die in der Prozesskammer der Hochvakuumanlage in der Nachbarschaft der Beschichtungsquelle gehalten ist. Hierbei ist die Linse zwischen zwei Ringen einlegbar, die über Drahtfedern gegeneinander verspannbar sind, wobei der erste Ring an seiner äußeren Mantelfläche mit Rampen versehen ist, die mit den Drahtfedern zusammenwirken, die an der radial äußeren Mantelfläche des zweiten Rings befestigt sind, wobei zumindest einer der Ringe an seiner radial äußeren Mantelfläche zwei sich diametral gegenüberliegende Zapfen aufweist, mit denen er sich in korrespondierenden Lagergabeln der Substrathalterung (abstützt und in denen er um etwa 180° drehbar ist.

DE 16 52 019 A1 offenbart eine Linsenumränderungsvorrichtung zum Entfernen überschüssigen Glases von der Kante eines Linsenrohlings, umfassend einen zentral auf der Oberfläche befestigten Block, ein Gestell, ein von dem Gestell getragenes Abriebkammergehäuse, ein sich drehendes Schleifrad mit einer Schleifkante in der Kammer, einen Träger zum Halten des Linsenrohlings mit seiner im Allgemeinen parallel zu der Kante liegenden Achse, ein erstes Mittel zum Drehen des Trägers gegen die Kante und von dieser fort, ein zweites Mittel zum Steuern der Bewegung des Trägers gegen das Schleifrad und von diesem fort entsprechend einem vorher angenommenen Muster, eine von dem Träger in der Kammer gehalterte Schleiffläche, einen auf dem Träger montierten Rückhaltearm, ein drittes Mittel zum Bewegen des Rückhaltearmes gegen die Schleiffläche und von dieser fort, ein viertes Mittel, welches den Träger entlang einer zu der mechanischen Linsenachse parallelen Achse gleitbar aufnimmt und wodurch der Umfang des Linsenrohlings bezüglich der Schleifkante justierbar ist.

DE 10 2006 041 137 A1 offenbart eine Vorrichtung und ein Verfahren zum Wenden einer ophthalmischen Kunststofflinse in einer Vakuum-Beschichtungsanlage, mit einer um eine Drehachse wendbar gelagerten Halterung für die Linse und mit einer die Halterung um die Drehachse wendenden Wendeeinrichtung. Hierbei ist vorgesehen, dass die Wendeeinrichtung eine Kraft, insbesondere eine magnetische Kraft erzeugt, welche die Halterung ohne mechanische Kopplung zwischen der Wendeeinrichtung und der Halterung wendet.

Trotz zahlreicher Vorteile beinhalten diese Vorrichtungen und Verfahren noch Verbesserungspotenzial. Insbesondere bei einem Einsatz der Vorrichtung DE 10 2006 041 137 A1 kann es nachteilig sein, wenn ein Brillenglas derart in einen Wendering eingespannt wird, dass der Schwerpunkt des Brillenglases höher als der Mittelpunkt der Drehachse des Wenderings liegt. Liegt der Schwerpunkt des Brillenglases nämlich zu weit von der Drehachse des Wenderings entfernt, kann der Wendering mit dem eingespannten Brillenglas in eine Ausgangsposition zurückfallen, bevor der Wendevorgang vollständig abgeschlossen ist. Der Wendevorgang eines Wenderings ist solange nicht vollständig abgeschlossen, wenn das Magnetfeld, das zum Wenden des Wenderings aktiviert wurde, abgeschaltet wird, bis der Wendering vollständig gewendet wurde. Dies kann beispielsweise am Ende eines Wendevorgangs bei dem letzten zu wendenden Brillenglas auf einem Kalotten-Kranz auftreten, insbesondere wenn das Magnetfeld abgeschaltet wird, bevor der am Anfang des Wendevorgangs bereits gewendete Wendering auf demselben Kranz davon erneut angezogen würde.

### Aufgabe der Erfindung

Vor dem Hintergrund der DE 10 2004 026 523 A1 besteht die Aufgabe der vorliegenden Erfindung darin, eine Wendeeinrichtung und eine damit räumlich fixierte Vorrichtung und ein Verfahren zur Einbringung einer optischen Linse, vorzugsweise eines Brillenglases, in die Wendeeinrichtung bereitzustellen, welche die aufgeführten Nachteile und Einschränkungen des Standes der Technik zumindest teilweise überwinden.

Insbesondere soll die Einbringung der Linse in die Wendeeinrichtung an eine über einen weiten Bereich beliebig vorgebbare Stelle der Wendeeinrichtung erfolgen können, erfindungsgemäß derart, dass dadurch ein Schwerpunkt der Linse in eine Drehachse gebracht wird, um welche die Wendeeinrichtung drehbar gelagert ist.

### Offenbarung der Erfindung

Diese Aufgabe wird gelöst durch eine Wendeeinrichtung und eine damit verbundene Vorrichtung sowie durch ein Verfahren mit den Merkmalen der unabhängigen Patentansprüche. Bevorzugte Ausgestaltungen, welche einzeln oder in Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben dem durch diese Begriffe eingeführten Merkmal, keine weiteren Merkmale vorhanden sind oder auf Situationen, in welchen ein oder mehrere weitere Merkmale vorhanden sind. Beispielsweise kann sich der Ausdruck "A hat B", "A weist B auf, "A umfasst B" oder "A schließt B ein" sowohl auf die Situation beziehen, in welcher, abgesehen von B, kein weiteres Element in A vorhanden ist, d.h. auf eine Situation, in welcher A ausschließlich aus B besteht, als auch auf die Situation, in welcher, zusätzlich zu B, ein oder mehrere weitere Elemente in A vorhanden sind, beispielsweise Element C, Elemente C und D oder sogar weitere Elemente.

In einem ersten Aspekt betrifft die vorliegende Erfindung eine Wendeeinrichtung und eine damit räumlich fixierte Vorrichtung zur Einbringung einer optischen Linse in die Wendeeinrichtung.

Der Begriff "Wendeeinrichtung" bezeichnet grundsätzlich eine beliebige Vorrichtung, die zu einer vorübergehenden oder dauerhaften Aufnahme eines Gegenstands ausgestaltet ist und die eine vorgegebene Drehachse aufweist, um welche die Vorrichtung drehbar gelagert ist. Der von der vorliegenden Erfindung umfasste Gegenstand betrifft hierbei eine optische Linse, vorzugsweise ein Brillenglas. Zum Zweck der Aufnahme der Linse weist die Wendeeinrichtung mindestens eine Halterung auf, in welcher die Linse während eines Zeitraums festgelegt wird, insbesondere um einen Verbund aus der Wendeeinrichtung und der Linse durch wenigstens einen Verfahrensschritt zu führen. Hierbei kann die Halterung grundsätzlich beliebig ausgestaltet sein und insbesondere mindestens einen Rahmen und mindestens ein in den Rahmen angebrachtes oder eingebrachtes Haltemittel aufweisen, welches dazu eingerichtet ist, um die Linse in einer durch das Haltemittel gebildeten Aufnahmeöffnung zu halten. Der Begriff des "Haltemittels" bezeichnet hierbei eine Einrichtung an der Halterung, welche die Aufnahmeöffnung zur Aufnahme der Linse darstellt oder ausbildet. Die Halterung selbst kann darüber hinaus weitere Elemente aufweisen, insbesondere den Rahmen zur Anbringung oder Einbringung des Haltemittels. Wie beispielsweise in DE 101 46 542 A1 und EP 1 295 962 A1 offenbart, kann das Haltemittel von einem Klemmabschnitt eines Halterungskörpers gebildet oder als Federelement ausgestaltet sein. Das Haltemittel kann hierzu einen Körper aufweisen, der als "Halterungskörper" bezeichnet wird, wobei das Haltemittel einteilig oder mehrteilig ausgestaltet sein kann. In einer bevorzugten Ausgestaltung kann der Halterungskörper mindestens ein Element aufweisen, welches dazu eingerichtet ist, die Linse durch einen Klemmvorgang an dem Halterungskörper festzulegen. Hierbei kann das für den Klemmvorgang eingerichtete Element Teil des Halterungskörpers sein und damit als "Klemmabschnitt" bezeichnet werden. In diesem Fall kann das Haltemittel somit einteilig ausgestaltet sein. Alternativ kann das für den Klemmvorgang eingerichtete Element als separates Element vorliegen und an dem Halterungskörper befestigt sein. In diesem Fall ist das Haltemittel somit mehrteilig ausgestaltet. In einer weiteren Ausgestaltung kann das Haltemittel ein Federelement sein oder umfassen, wobei der Begriff des "Federelements" eine Bauteil betrifft, das über Windungen verfügt, welche sich mechanisch verformen lassen und daher als Aufnahmeöffnung zur Aufnahme der Linse dienen können. Andere Arten von Haltemitteln sind jedoch möglich.

Wie bereits erwähnt, weist die Wendeeinrichtung eine vorgegebene Drehachse auf, um welche die Vorrichtung drehbar gelagert ist. Der Begriff der "Drehachse" oder der "Rotationsachse" bezeichnet hierbei eine Achse, insbesondere eine vorgegebene Achse, um welche die Wendeeinrichtung um einen Winkel, vorzugsweise um einen beliebigen Winkel, gedreht werden kann. Insbesondere um eine Drehachse eindeutig vorzugeben, kann die Wendeeinrichtung hierbei eine, an eine Außenseite der Wendeeinrichtung angebrachte Einrichtung, bevorzugt in Form von gegenüber an der Außenseite angeordneten zylinderförmigen oder konischen Stäben, verfügen, welche einerseits in ein zur Aufnahme der Wendeeinrichtung vorgesehenes Lagerelement einfügbar ist und andererseits damit als Welle für das Lagerelement dienen kann. Aufgrund der Drehachse kann die Wendeeinrichtung somit die Linse nicht nur festhalten, sondern die Linse während ihres Festhaltens um einen Winkel, vorzugsweise um einen beliebigen Winkel, drehen. Die Wendeeinrichtung ist hierbei für ein Wenden der Linse, d.h. eine Drehung der Linse um einen Winkel von ± 180°, eingerichtet. Der angegebene

Winkel von ± 180° schließt hierbei fachmännisch geläufige Toleranzen mit ein, insbesondere eine Abweichung von 15°, bevorzugt von 5°. Damit lässt sich bevorzugt eine Bearbeitung der Linse, vorzugsweise eine Beschichtung des Brillenglases in der Vakuumbeschichtungsanlage, auf beiden Seiten der Linse, vorzugsweise des Brillenglases, ermöglichen.

In einer besonders bevorzugten Ausgestaltung kann die Wendeeinrichtung in Form eines Wenderings vorliegen. Der Begriff des "Wenderings" bezeichnet eine Wendeeinrichtung, welche, in Aufsicht betrachtet, die Form eines kreisförmig, elliptisch oder oval ausgestalten Rings annimmt, wobei die Form des Wenderings bevorzugt an die aufzunehmende Linse, insbesondere an das aufzunehmende Brillenglas, angepasst ist.

Der Begriff des "Einbringen" oder der "Einbringung" bezeichnet im Rahmen der vorliegenden Erfindung grundsätzlich ein beschädigungsfreies Einfügen der Linse mittels der Vorrichtung in die Wendeeinrichtung. Vorzugsweise wird hierunter verstanden, dass die Linse, insbesondere das Brillenglas, durch das Haltemittel der Wendeeinrichtung, aufgenommen, in der hierdurch gebildeten Aufnahmeöffnung festgehalten und im festgelegten Zustand bei Bedarf oder nach Zeitablauf um einen Winkel um die Drehachse der Wendeeinrichtung gedreht werden kann.

Die hier vorgeschlagene Vorrichtung umfasst einen Trägerkörper und ein Trägerelement zur Aufnahme der Linse. Der Begriff des "Trägerkörpers" bezeichnet hierbei einen grundsätzlich beliebigen Teil der Vorrichtung, welcher einerseits dazu eingerichtet ist, das Trägerelement aufzunehmen und anderseits eine Handhabung der Vorrichtung zu ermöglichen oder zumindest zu erleichtern, ohne hierbei direkt das Trägerelement zu beaufschlagen. In einer bevorzugten Ausgestaltung kann der Trägerkörper hierzu eine Aussparung aufweisen, insbesondere eine der Wendeeinrichtung oder der unten beschriebenen Auflage für die Wendeeinrichtung zugewandte Aussparung, in welche das Trägerelement eingebracht ist. Durch die Aussparung kann die Linse so auf das Trägerelement aufgebracht werden, um ein Rutschen der Linse von dem Trägerelement möglichst weitgehend zu vermeiden. Alternative Ausgestaltungen sind jedoch möglich, etwa ein Durchbruch, in welchen das Trägerelement eingebracht ist. Der Trägerkörper kann darüber hinaus eine Außenseite aufweisen, auf welche ein Handhabungselement zugreifen und auf diese Weise die Handhabung der vorgeschlagenen Vorrichtung vornehmen kann.

Der Begriff des "Trägerelements" bezeichnet hierbei einen grundsätzlich beliebigen Teil der Vorrichtung, welcher zu einer vorübergehenden Aufnahme der Linse ausgestaltet ist, insbesondere bis die Linse in die Wendeeinrichtung eingebracht ist. Hierzu weist das Trägerelement eine Auflagefläche auf. Der Begriff der "Auflagefläche" bezeichnet hierbei eine nicht notwendigerweise ebene Auflagefläche, welche zur Aufnahme der Linse eingerichtet ist. Hierbei weist die Auflagefläche eine laterale Ausdehnung in zwei Dimensionen auf, welche sich zur Aufnahme der Linse eignet. Hierbei kann die Auflagefläche eine runde, ovale, quadratische, rechtwinklige oder hexagonale Fläche aufweisen. In einer bevorzugten Ausgestaltung kann die Auflagefläche Teil einer Auflageplatte sein. Andere Arten der Ausgestaltung der Auflagefläche sind jedoch denkbar. Durch diese Ausgestaltung des Trägerelements, das über eine Auflagefläche verfügt, kann insbesondere eine einfache und sichere Art der Einbringung, Lagerung, Bewegung und Transport der Linse auf dem Trägerelement erreicht werden. Ungeachtet der Art ihrer Ausführung kann die Auflagefläche vorzugsweise so ausgestaltet sein, dass ihre Fläche die zur Auflage der Linse erforderliche Fläche nur geringfügig übersteigt.

In einer besonderen Ausgestaltung kann die Auflagefläche nicht eben ausgestaltet sein, sondern ein Höhenprofil aufweisen, welches vorzugsweise einen Höhenunterschied von größer als 0 mm bis zu 10 mm aufweist. Dadurch kann eine Linse, insbesondere ein Brillenglas, die über keine runde Randform verfügt, sondern zum Beispiel eine ovale Randform aufweist, leichter in die Wendeeinrichtung eingebracht werden, vor allem weil durch eine hierdurch mögliche Höhenanpassung die Randform des betreffenden Brillenglases besser durch das Haltemittel, bevorzugt den Klemmabschnitt des Halterungskörpers oder das Federelement, vorzugsweise die mindestens eine Spannfeder, aufgenommen werden kann.

In einer besonders bevorzugten Ausgestaltung kann ein Abstand zwischen einem Rand der Auflagefläche zu dem Trägerkörper, welcher insbesondere in Form eines Spaltes vorliegen kann, möglichst klein gewählt werden, insbesondere kleiner als 2 mm, bevorzugt kleiner als 1 mm. Auf diese Weise kann verhindert werden, dass ein Rand einer Linse, vor allem eines Brillenglases, in den Spalt rutschen und dort, quasi in einer Funktion eines Keiles, eine unten näher beschriebene Bewegung der Auflageplatte behindern kann.

Erfindungsgemäß weist der Trägerkörper weiterhin mindestens eine Auflage auf, welche dazu eingerichtet ist, um die Wendeeinrichtung aufzunehmen.

Der Begriff der "Auflage" bezeichnet hierbei einen grundsätzlich beliebigen Teil der vorgeschlagenen Vorrichtung, dessen Lage und Form derart ausgestaltet ist, dass die Vorrichtung und die Wendeeinrichtung mittels der Auflage auf eine festgelegte Weise zueinander fixiert werden können. Dadurch kann eine räumliche Fixierung der Vorrichtung in Bezug auf die Wendeeinrichtung vereinfacht werden. Alternativ kann eine Fixierung der Vorrichtung in Bezug auf ein die Wendeeinrichtung umgebendes Element, beispielsweise ein Segment einer Kalotte der Beschichtungsanlage, vorgenommen werden.

Die Vorrichtung eignet sich für eine optische Linse, besonders bevorzugt für ein Brillenglas. Unter einer optischen Linse wird im Rahmen der vorliegenden Erfindung ein optisch transparentes Element verstanden, welches über zwei lichtbrechende Flächen verfügt, die einander gegenüberliegend angeordnet sind. Da Linsen ein optisch transparentes Material, insbesondere ausgewählt aus Glas, Quarz oder einem transparenten organischen Kunststoff, aufweisen, ist eine schonende Behandlung der Linse und insbesondere ihrer Oberfläche besonders vorteilhaft. Unter der "schonenden Behandlung" wird eine möglichst kraft- und reibungsarme Beaufschlagung der Linse mit der Vorrichtung verstanden, wozu sich die hier vorgeschlagene Vorrichtung in vorteilhafter Weise eignet. Für eine Verwendung der Vorrichtung eignen sich vorzugsweise Brillengläser, welche, insbesondere abhängig von einer räumlichen Ausdehnung des Trägerelements, eine Größe von 1 cm bis 1 m, bevorzugt von 2 cm bis 50 cm, aufweisen.

Unter einem "Brillenglas" wird im Rahmen der vorliegenden Erfindung eine optische Linse verstanden, welche gemäß DIN EN ISO 13666:2013-10, Abschnitte 8.1.1 und 8.1.2 zur Messung und/oder Korrektion von Fehlsichtigkeiten und/oder zum Schutz des Auges oder zur Änderung seines Aussehens dienen soll, wobei die optische Linse vor dem Auge, aber nicht in Kontakt mit dem Auge getragen wird. Das Brillenglas weist ein optisch transparentes Material, insbesondere ausgewählt aus Glas, Quarz oder einem transparenten organischen Kunststoff.

Unabhängig von seiner tatsächlichen Ausgestaltung weist die Linse einen Schwerpunkt auf. Der Begriff des "Schwerpunkts" oder "Massenmittelpunkts" bezeichnet hierbei einen gedachten Punkt innerhalb oder außerhalb eines Volumens, das die Linse einnimmt, welcher einem Mittel der Lage aller Masseelemente der Linse entspricht, welche mit der jeweiligen Masse des betreffenden Masseelements gewichtet sind. Liegt, wie insbesondere im Falle von Brillengläsern, innerhalb des Volumens des Brillenglases eine praktisch homogene Massenverteilung mit im Wesentlichen gleicher Dichte vor, so stimmt der Schwerpunkt des Brillenglases mit einem geometrischen Schwerpunkt, welcher dem Mittel aller Volumenelemente innerhalb des Volumens des Brillenglases entspricht, überein.

Gemäß der vorliegenden Erfindung wird vorgeschlagen, das Trägerelement derart verschiebbar gegenüber dem Trägerkörper zu lagern, dass dadurch die Linse in die Wendeeinrichtung einbringbar ist. Der Begriff "verschiebbar" bezeichnet hierbei eine Eigenschaft einer Anbringung des Trägerelements in dem Trägerkörper, gemäß welcher das Trägerelement bei Einwirkung einer Kraft auf das Trägerelement seine Position oder Lage in mindestens eine ausgezeichnete Richtung, bevorzugt in genau eine ausgezeichnete Richtung, insbesondere entlang einer vorgegebenen Achse, ändern kann. In Folge der Änderung der Lage des Trägerelements wird hierdurch eine von dem Trägerelement aufgenommene Linse, welche sich vorzugsweise auf der Auflagefläche der Auflageplatte befindet, zusammen mit dem Trägerelement bewegt. Erfindungsgemäß kann somit die Änderung der Lage des Trägerelements in Bezug auf den Trägerkörper derart erfolgen, dass sich die Lage des Trägerelements auf eine Weise ändert, dass hierdurch die von dem Trägerelement aufgenommene Linse solange bewegt wird, bis sie durch diese Bewegung in die Wendeeinrichtung eingebracht ist.

Gemäß der vorliegenden Erfindung wird somit die Linse so lange verschoben, bis der Schwerpunkt der Linse in die Drehachse, um welche die Wendeeinrichtung drehbar gelagert ist, gebracht ist. Auf diese Weise wird, wie eingangs erwähnt, die Linse, insbesondere das Brillenglas, derart in die Wendeeinrichtung eingespannt, dass der Schwerpunkt der Linse schließlich auf der Drehachse der Wendeeinrichtung zu liegen kommt. Auf diese Weise kann ermöglicht werden, dass der Wendevorgang des Wenderings vollständig abgeschlossen werden kann, auch wenn das Magnetfeld, das zum Wenden des Wenderings aktiviert wurde, vorher abgeschaltet wurde. Der Begriff des "Wendevorgangs" beschreibt hierbei einen Ablauf, bei dem die Wenderinge, welche auf die Segmente einer Kalotte aufgebracht sind, gewendet werden. Hierbei werden in der Regel nicht alle Wenderinge gleichzeitig gewendet, sondern nacheinander innerhalb einer Lage auf einem Kalotten-Kranz. Der Wendevorgang eines einzelnen Wenderings erfolgt dann, wenn während einer Rotation der Kalotte der Wendering an einer Wendeeinrichtung, welche ein Magnetfeld bereitstellt, vorbeigeführt wird. Wird hierbei der magnetisierbare Wendering vom dem Magnetfeld angezogen, beginnt er, um die Drehachse des Wenderings zu rotieren, insbesondere um einen Winkel von ± 180°. Andere Arten der Ausgestaltung des Wendevorgangs sind jedoch möglich.

Der Trägerkörper weist mindestens eine Auflage zur Aufnahme der Wendeeinrichtung auf, um so die Vorrichtung und die Wendeeinrichtung auf eine festgelegte Weise räumlich zueinander zu fixieren. Das Trägerelement ist ferner verschiebbar gegenüber der Auflage gelagert. Dadurch wird die Verschiebung des Schwerpunkts der Linse in die Drehachse, um welche die Wendeeinrichtung drehbar gelagert ist, ermöglicht.

In einer besonders bevorzugten Ausgestaltung der vorliegenden Erfindung kann das Trägerelement stufenlos verschiebbar sein, und zwar einerseits gegenüber dem Trägerkörper und vorzugsweise andererseits auch gegenüber der Auflage zur Aufnahme der Wendeeinrichtung. Der Begriff "stufenlos" beschreibt hierbei eine Art der Verschiebung, welche einen grundsätzlich beliebigen Wert innerhalb eines Intervalls, welches begrenzt ist aus einer minimalen Verschiebung und einer maximalen Verschiebung, einnehmen kann. Insbesondere bei der Einbringung von Brillengläsern in den Wendering kann ein Intervall von größer als 0 mm bis zu 30 mm, innerhalb dessen die Verschiebung, insbesondere die stufenlose Verschiebung, des Trägerelements möglich ist, besonders bevorzugt sein. Die stufenlose Verschiebung weist insbesondere den Vorteil auf, dass die Einbringung des Schwerpunkts der Linse in die Drehachse, um welche die Wendeeinrichtung drehbar gelagert ist, auf besonders einfache und genaue Weise erfolgen kann. In einer alternativen, jedoch weniger bevorzugten Ausgestaltung kann das Trägerelement inkrementell, d.h. in kleinen Schritten, verschiebbar sein.

Um die Verschiebung, insbesondere die stufenlose Verschiebung, des Trägerelements vornehmen zu können, kann eine Verschiebeeinrichtung vorgesehen sein, welche dazu eingerichtet ist, um das Trägerelement verschiebbar gegenüber dem Trägerkörper zu lagern. Der Begriff der "Verschiebeeinrichtung" bezeichnet hierbei grundsätzlich eine beliebige Einrichtung, welche dazu ausgestaltet ist, um die Verschiebung, insbesondere die stufenlose Verschiebung, des Trägerelements ausführen zu können. Hierbei kann es sich bevorzugt um eine mechanische Einrichtung handeln, insbesondere ausgewählt aus einer Federeinrichtung, einer Schraubeinrichtung oder einer hydraulischen Einrichtung. Andere Arten von Verschiebeeinrichtungen sind jedoch denkbar. In einer bevorzugten Ausgestaltung kann hierbei die Verschiebung der Auflageplatte durch eine Federlagerung der Auflageplatte auf Druckfedern erreicht werden. Der Begriff der "Federlagerung" beschreibt hierbei eine Lagerung des Trägerelements auf einem elastischen Element, das derart eine Kraft auf das Trägerelement ausüben kann, dass hierdurch eine Verschiebung des Trägerelements bewirkt werden kann. Alternativ kann anstelle einer mechanischen Federung auch eine andere Art der Federung eingesetzt werden, insbesondere eine Federung mittels eines elastischen Materials, vorzugsweise unter Verwendung eines Schaumstoffs, eines Gummis oder eines Luftballs. Andere Arten der Federung sind jedoch möglich. Der Begriff der "Schraubeinrichtung" bezeichnet hierbei eine Einrichtung, die eine Verschiebung des Trägerelements durch eine mittels Rotation der Einrichtung hervorgerufen Kraft auf das Trägerelement bewirken kann. Der Begriff der "hydraulischen Einrichtung" betrifft eine Einrichtung, welche eine Verschiebung des Trägerelements durch Verwendung einer Flüssigkeit, insbesondere Wasser, einer wässrigen Lösung oder Öl, zur Erzeugung einer Kraft auf das Trägerelement bewirken kann. Unabhängig von ihrer Ausgestaltung kann die Verschiebeeinrichtung insbesondere den Vorteil aufweisen, dass dadurch die Verschiebung der Linse auf einfache und festlegbare Weise erfolgen kann.

Bei der Verschiebung des Trägerelements kann in vorteilhafter Weise ausgenutzt werden, dass die Lage des Schwerpunkts der Linse, insbesondere des Brillenglases, ausreichend gut mit dessen Form und Gewicht korrelieren kann. Dies kann sich vor allem in positiver Hinsicht auf die Federeinrichtung, insbesondere die Druckfeder auswirken, welche sich mittels ihrer Federkraft der von dem Trägerelement und der sich darauf befindlichen Linse ausgeübten Schwerkraft entgegenstellen und auf diese Weise ein Gleichgewicht bewirken kann.

Vor allem im Hinblick auf die geometrische Form der Brillengläser kann allerdings zu unterscheiden sein, ob es sich um ein Brillenglas mit positiver optischer Wirkung, das auch als "Plus-Glas" bezeichnet wird, oder um ein Brillenglas mit negativer optischer Wirkung, das auch als "Minus-Glas" bezeichnet wird, handelt. Hierbei kann sich insbesondere die Dicke des Glasrands, welcher dick bei Minus-Gläsern und dünn bei Plus-Gläsern ist, sowie die Dicke in der Glasmitte, welche dünn bei Minusgläsern und dick bei Plus-Gläsern ist, voneinander unterscheiden. Je nach optischer Wirkung des Brillenglases kann hierdurch eine unterschiedliche Art der Korrelation zwischen der Krafteinwirkung auf das Trägerelement und der dadurch bewirkten Verschiebung des Trägerelements auftreten, welche der Fachmann jedoch auf einfache Weise berücksichtigen kann. Mit der vorliegenden Vorrichtung kann somit bei dem Einbringen der Brillengläser in den Wendering eine Anpassung von vielfältigen Schwerpunktlagen unterschiedlicher Brillengläser an die Lage der Drehachse des Wenderings durch das verschiebbare Trägerelement erreicht werden, welches in seiner Höhe vorzugsweise stufenlos verschiebbar ist.

In einer weiteren bevorzugten Ausgestaltung kann die Vorrichtung weiterhin mindestens eine Führungseinrichtung zur Führung des Trägerelements aufweisen. Der Begriff der "Führungseinrichtung" bezeichnet hierbei grundsätzlich eine beliebige Einrichtung, welche eine mechanische Unterstützung für das Trägerelement während der Verschiebung des Trägerelements bereitstellt. Die Führungseinrichtung kann hierbei bevorzugt mindestens eine, vorzugsweise mehrere zylindrische oder konische Führungsstangen aufweisen, welche, in einen dafür vorgesehenen Schaft geführt, in das Trägerelement eingreifen können. Andere Ausgestaltungen der Führungseinrichtung sind jedoch möglich. Mittels der Führungseinrichtung kann eine Verschiebung des Trägerelements in eine gewünschte Richtung, insbesondere in Richtung der Drehachse der Wendeeinrichtung, ohne ein Verkippen des Trägerelements ermöglicht werden, vor allem um ein Abrutschen der Linse von dem Trägerelement, insbesondere von der Auflagefläche, zu verhindern.

In einer besonders bevorzugten Ausgestaltung kann die Verschiebeeinrichtung, bevorzugt die Federeinrichtung, insbesondere die mindestens eine Druckfeder, und/oder die Führungseinrichtung, insbesondere die mindestens eine Führungsstange, in der Nähe eines Rands des Trägerelements, insbesondere der Auflageplatte, angeordnet sein, vor allem um eine möglichst stabile Lage des Trägerelements, insbesondere der Auflageplatte, zu erzielen. In dieser Ausgestaltung kann ein Mittelpunkt einer Mittelsenkrechten der Federeinrichtung und/oder der Führungsstange weniger als ein Viertel einer mittleren Ausdehnung des Trägerelements, insbesondere eines Durchmessers der Auflageplatte, vom Rand entfernt angebracht sein. Andere Arten der Anbringung der Verschiebeeinrichtung und/oder der Führungseinrichtung sind jedoch möglich.

In einer weiteren bevorzugten Ausgestaltung kann die Auflagefläche für die Linse, insbesondere für das Brillenglas, und/oder die Auflage für die Wendeeinrichtung, insbesondere für den Wendering, gleitreibungsarm ausgeführt sein, vor allem dass sich so die Linse und/oder die Wendeeinrichtung beim Einspannen möglichst leicht bewegen lassen. Weiterhin können auch Oberflächen der Verschiebeeinrichtung, bevorzugt der Federeinrichtung, insbesondere der mindestens einen Druckfeder, und/oder der Führungseinrichtung, insbesondere der mindestens einen Führungsstange, reibungsarm ausgeführt sein, vor allem dass so die Verschiebeeinrichtung und/oder die Führungseinrichtung, möglichst leicht beweglich sind. Der Begriff "reibungsarm" bezeichnet hierbei jeweils einen Reibungskoeffizienten für eine Gleitreibung nach DIN 53375 von 0,02 bis 0,5.

In einer besonderen Ausführung kann das Trägerelement, insbesondere die Auflageplatte, über Bolzen verfügen, welche zum Spreizen der Spannfedern, die als das Haltemittel in der Wendeeinrichtung dienen können, eingesetzt werden können. Zum Spreizen der Spannfedern kann der Wendering bevorzugt im Uhrzeigersinn gedreht werden. Diese Bolzen können hierbei als Teil des Trägerkörpers ausgestaltet sein oder als separates Teil auf den Trägerkörper gelegt werden. Hierbei können die Bolzen gegenüber den Enden eines Sternteils liegen, welches als Teil des Trägerelements ausgestaltet ist oder als separates Teil auf das Trägerelement legbar ist. In dieser Ausführung kann eine laterale Abmessung der Bolzen mindestens so groß sein wie eine größte laterale Ausdehnung eines Federteils der Spannfedern, welches beim Spreizen der Spannfedern nicht an dem Bolzen entlanggeführt wird. Auf diese Weise kann jede der Spannfedern, auch wenn das Ende der Spannfeder nach innen gebogen ist, weit genug von dem Trägerelement, insbesondere der Auflageplatte, entfernt sein, dass sich das Trägerelement, insbesondere die Auflageplatte, möglichst ohne Hinderung bewegen kann.

In einem weiteren Aspekt betrifft die vorliegende Erfindung ein Verfahren zur Einbringung einer optischen Linse in eine Wendeeinrichtung. Das Verfahren umfasst die Schritte des unabhängigen Anspruchs 10. Weiterhin können einzelne, mehrere oder alle Schritte des Verfahrens wiederholt, insbesondere mehr als einmal, ausgeführt werden. Das Verfahren kann, zusätzlich zu den genannten Verfahrensschritten auch weitere Verfahrensschritte umfassen.

Bei dem Bereitstellen der Vorrichtung zur Einbringung einer Linse in eine Wendeeinrichtung in einem Ausgangszustand in Verfahrensschritt a) handelt es sich insbesondere um die Vorrichtung, welche an anderer Stelle in diesem Dokument näher beschrieben wird. Dementsprechend kann für Definitionen und optionale Ausgestaltungen weitgehend auf die Beschreibung der Vorrichtung verwiesen werden.

Gemäß Verfahrensschritt b) erfolgt ein Aufbringen einer handzuhabenden Linse auf das Trägerelement. Wie oben beschrieben, kann es sich hierbei besonders bevorzugt um ein Brillenglas, handeln. Hierbei kann das Aufbringen der handzuhabenden Linse manuell, bevorzugt jedoch mittels einer automatischen Handhabungseinrichtung, beispielsweise mittels eines Roboters, erfolgen.

Gemäß Verfahrensschritt c) erfolgt die Einbringung der Linse von dem Trägerelement in die Wendeeinrichtung in einer erfindungsgemäßen Weise, gemäß der das Trägerelement derart gegenüber dem Trägerkörper verschoben wird, dass dadurch die Linse in die Wendeeinrichtung eingebracht wird.

Hierbei wird der Schwerpunkt der Linse in eine Drehachse gebracht, um welche die Wendeeinrichtung drehbar gelagert ist.

Für weitere Einzelheiten in Bezug auf die vorliegenden Verfahren wird auf die übrige Beschreibung der Vorrichtung verwiesen.

Die erfindungsgemäße Wendeeinrichtung und damit räumlich fixierte Vorrichtung und die vorliegenden Verfahren weisen gegenüber herkömmlichen Vorrichtungen und Verfahren, welche über ein starres Trägerelement verfügen, zahlreiche Vorteile auf. Insbesondere kann durch die in diesem Dokument beschriebene Federlagerung des Trägerelements beim Auflegen eines Brillenglases die Auflageplatte gerade so weit nach unten verschoben werden, dass die Lage des Schwerpunkts des Brillenglases möglichst genau auf die Höhe der Drehachse des zugehörigen Wenderings, in welchen das Brillenglas eingeführt werden soll, gelangt. Dadurch kann vor allem ein Kraftaufwand für das Wenden des Wenderings mit eingespanntem Brillenglas minimiert werden. Weiterhin kann dadurch ermöglicht werden, dass ein vollständiger Wendevorgang des Wenderings mit eingespanntem Brillenglas, der einer Drehung des Brillenglases um ±180° entspricht, auch dann vollständig abgeschlossen werden kann, wenn das zur Durchführung des Wendevorgangs eingesetzte Magnetfeld abgeschaltet wird, bevor der Wendevorgang beendet ist, sich der Wendering jedoch bereits um mehr als 90° gedreht hat. Darüber hinaus kann ein Einspannen von Brillengläsern mit sehr dicken Rändern in den Wendering erleichtert werden, vor allem da eine Höhe der Auflageflache gegenüber der Drehachse des Wenderings nicht durch eine manuelle Einstellung angepasst werden muss, beispielsweise durch ein Herausnehmen eines Sternteils bei einer herkömmlichen Vorrichtung.

### Kurze Beschreibung der Figuren

Weitere Einzelheiten und Merkmale der Erfindung ergeben sich aus der nachfolgenden Beschreibung von bevorzugten Ausführungsbeispielen, insbesondere in Verbindung mit den Unteransprüchen. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigen:
Figur 1 eine Querschnittdarstellung (Figur 1A) und eine Aufsicht (Figur 1B) eines bevorzugten Ausführungsbeispiels einer Wendeeinrichtung und einer damit räumlich fixierten Vorrichtung;
Figur 2 eine Querschnittdarstellung von bevorzugten Gegenständen und ihren zugehörigen Schwerpunkten; und
Figur 3 ein Ablaufdiagramm eines erfindungsgemäßen Ausführungsbeispiels eines Verfahrens zur Einbringung eine optischen Linse in eine Wendeeinrichtung.

### Ausführungsbeispiele

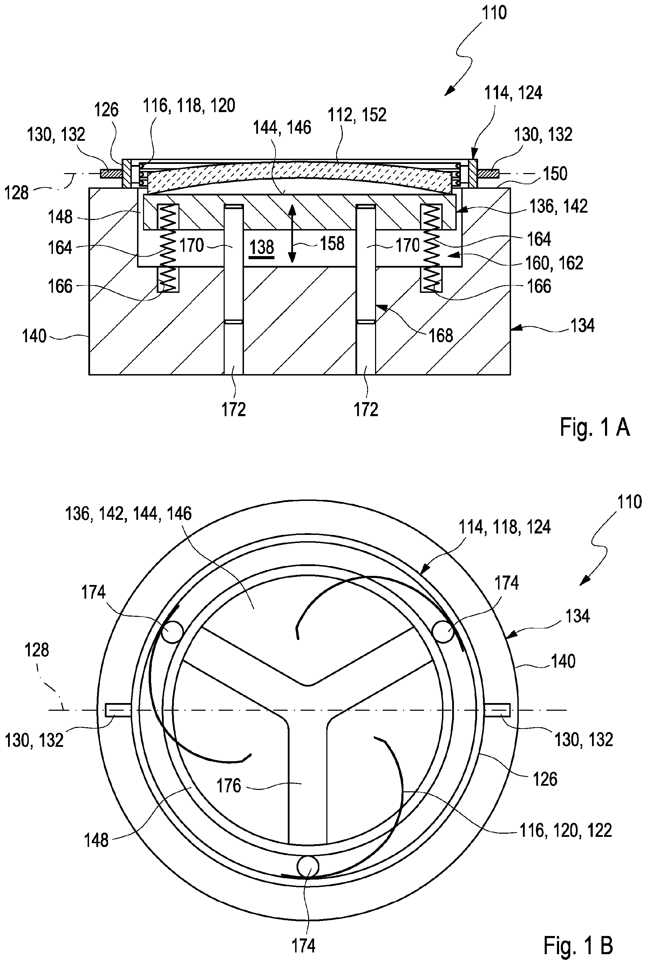

Figur 1 zeigt eine schematische Darstellung einer Vorrichtung 110 zur Einbringung einer optischen Linse 112 in eine Wendeeinrichtung 114 im Querschnitt (Figur 1A) und in Aufsicht (Figur 1B). Die Vorrichtung 110 kann hierbei insbesondere ein beschädigungsfreies Einfügen der Linse 112 in die Wendeeinrichtung 114 ermöglichen.

Die Wendeeinrichtung 114, welche zu einer vorübergehenden oder dauerhaften Aufnahme der Linse 112 eingerichtet ist, kann zu diesem Zweck mindestens eine Halterung 116 aufweisen, in welcher die Linse 112 während eines Zeitraums festgelegt werden kann. Hierzu kann die Halterung 116 einen Rahmen 118 und mindestens ein in den Rahmen angebrachtes oder eingebrachtes Haltemittel 120 aufweisen. Hierbei kann das Haltemittel 120, wie in DE 101 46 542 A1 oder EP 1 295 962 A1, zum Beispiel von einem Klemmabschnitt eines Halterungskörpers gebildet (nicht dargestellt) oder, wie in Figur 1B dargestellt, als Federelement in Form von Spannfedern 122 ausgeführt sein kann. Andere Arten von Haltemitteln 120 sind jedoch möglich.

Die in Figur 1 schematisch dargestellte Ausführung der Wendeeinrichtung 114 liegt in Form eines Wenderings 124 vor, wobei der Wendering 124 zusätzlich zu der Halterung 116 zur Aufnahme der Linse 112 über eine, an einer Außenseite 126 des Wenderings 124 angebrachte, zur Festlegung einer Drehachse 128 vorgesehene Einrichtung 130 verfügt. Hierdurch kann der Wendering 124 um einen beliebigen Winkel um die Drehachse 128 bewegt werden kann. Die an der Außenseite 126 des Wenderings 124 angebrachte Einrichtung 130 weist zylinderförmige Stäbe 132 auf, welche einander gegenüberliegend an der Außenseite 126 des Wenderings 124 angeordnet sind. Die Stäbe 132 sind einerseits in ein zu deren Aufnahme vorgesehenes Lagerelement (nicht dargestellt) einfügbar und dienen andererseits damit als Welle für das Lagerelement. Damit kann der Wendering 124 die Linse 112 nicht nur festhalten, sondern ihn während des Festhaltens gleichzeitig auch um einen Winkel drehen, insbesondere um so eine Bearbeitung der Linse 112, vorzugsweise eine Beschichtung der Linse 112 in einer Vakuum-Beschichtungsanlage, von beiden Seiten zu ermöglichen. Der Wendering 124 ist daher für eine Drehung der Linse 112 um einen Winkel von ± 180° unter Berücksichtigung fachmännisch geläufiger Toleranzen, insbesondere unter Berücksichtigung einer Abweichung von 15°, bevorzugt von 5°, eingerichtet.

Die in Figur 1 schematisch dargestellte Vorrichtung 110 umfasst einen Trägerkörper 134 und ein Trägerelement 136 zur Aufnahme der Linse 112, wobei der Trägerkörper 134 einerseits dazu eingerichtet ist, das Trägerelement 136 aufzunehmen und anderseits eine Handhabung der Vorrichtung 110 zu ermöglichen oder zumindest zu erleichtern, ohne dass hierbei das Trägerelement 136 direkt beaufschlagt wird. Der in Figur 1 schematisch dargestellte Trägerkörper 134 weist eine Aussparung 138 auf, in welche das Trägerelement 136 eingebracht ist. Alternativ kann der Trägerkörper 134 über einen Durchbruch (nicht dargestellt) verfügen, in welchen das Trägerelement 136 eingebracht ist. Der Trägerkörper 134 kann ferner eine Außenseite 140 aufweisen, auf welche ein Handhabungselement zugreifen und so die Handhabung der Vorrichtung 110 vornehmen kann.

Die in Figur 1 schematisch dargestellte Ausführung des Trägerelements 136 umfasst eine Auflageplatte 142, die über eine Auflagefläche 144, die zur Aufnahme der Linse 112 eingerichtet ist verfügt. Wie Figur 1 zeigt, kann die Auflagefläche 144 vorzugsweise als runde Auflagefläche 146 ausgeführt sein; eine andere Ausführung der Auflagefläche 144 ist jedoch möglich, zum Beispiel eine ovale, quadratische, rechtwinklige oder hexagonale Auflagefläche. In einer besonderen Ausführung (nicht dargestellt) kann die Auflagefläche 144 nicht eben ausgeführt sein, sondern ein Höhenprofil aufweisen, welches vorzugsweise einen Höhenunterschied von größer als 0 mm bis zu 10 mm aufweist. In einer besonders bevorzugten Ausführung kann ein Abstand zwischen einem Rand der Auflagefläche 144 zu dem Trägerkörper 134 in Form eines Spaltes 148 vorliegen und hierbei möglichst klein gewählt werden, insbesondere kleiner als 2 mm, bevorzugt kleiner als 1 mm. Dadurch kann verhindert werden, dass ein Rand der Linse 112 in den Spalt 148 rutschen und dort, quasi in einer Funktion eines Keiles, eine Bewegung der Auflageplatte 142 behindern kann.

Der in Figur 1 schematisch dargestellte Trägerkörper 134 verfügt ferner über eine Auflage 150, welche dazu eingerichtet ist, den Wendering 124 aufzunehmen. Hierzu sind Lage und Form der Auflage 150 derart ausgeführt, dass die Vorrichtung 110 und der Wendering 124 mittels der Auflage 150 auf eine festgelegte Weise zueinander fixiert werden können. Dadurch kann eine räumliche Fixierung der Vorrichtung 110 in Bezug auf den Wendering 124 vereinfacht werden. Andere Arten der Fixierung sind jedoch möglich.

Die in Figur 1 schematisch dargestellte Vorrichtung 110 eignet sich für eine beliebige Linse 112, solange das Trägerelement 136 zur Aufnahme der Linse 112 eingerichtet ist. Abhängig von einer räumlichen Ausdehnung des Trägerelements 136, kann die Linse 112 somit eine Größe von 1 cm bis 1 m, bevorzugt von 2 cm bis 50 cm, aufweisen. Vorzugsweise kann die Vorrichtung 110 für ein optisches Element, besonders bevorzugt für ein Brillenglas 152, verwendet werden. Hierzu kann das Brillenglas 152 vorzugsweise als brechende optische Linse oder als Linsensystem ausgestaltet sein und weist ein optisch transparentes Material, insbesondere ausgewählt aus Glas, Quarz oder einem transparenten organischen Kunststoff, auf.

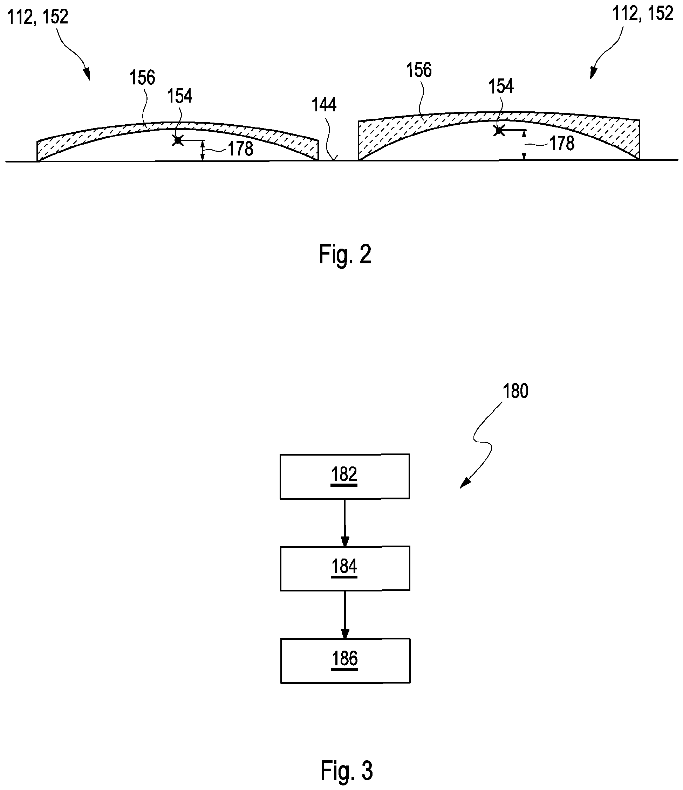

Wie in Figur 2 schematisch dargestellt, weist die Linse 112, insbesondere das Brillenglas 152, einen Schwerpunkt 154 auf. Der Schwerpunkt 154 bezeichnet hierbei einen gedachten Punkt innerhalb oder außerhalb eines Volumens 156, welches das Brillenglas 152 einnimmt, welcher einem Mittel der Lage aller Masseelemente der Linse 112 entspricht, welche mit der jeweiligen Masse des betreffenden Masseelements gewichtet sind. Liegt, wie im Falle von optischen Elementen, insbesondere von Brillengläsern 152, innerhalb des Volumens 156 des Brillenglases 152 eine praktisch homogene Massenverteilung mit im Wesentlichen gleicher Dichte vor, so stimmt der Schwerpunkt 154 des Brillenglases 152 mit einem geometrischen Schwerpunkt, welcher dem Mittel aller Volumenelemente innerhalb des Volumens 156 des Brillenglases 152 entspricht, überein.

Das in Figur 1 schematisch dargestellte Trägerelement 136 ist erfindungsgemäß derart verschiebbar gegenüber dem Trägerkörper 134 gelagert, dass dadurch die Linse 112 in den Wendering 124 einbringbar ist. Die Möglichkeit einer Verschiebbarkeit des Trägerelements 136 gegenüber dem Trägerkörper 134 bewirkt, dass das Trägerelement 136 bei Einwirkung einer Kraft auf das Trägerelement 136 seine Position oder Lage in eine Richtung 158 ändern kann. In Folge der Änderung der Lage des Trägerelements 136 wird hierdurch die von dem Trägerelement 136 aufgenommene Linse 112 zusammen mit dem Trägerelement 136 bewegt. Somit erfolgt die Anderung der Lage des Trägerelements 136 in Bezug auf den Trägerkörper 134 derart, dass sich die Lage des Trägerelements 136 so ändert, dass hierdurch die von dem Trägerelement 136 auf der Auflagefläche 144 der Auflageplatte 142 aufgenommene Linse 112 solange bewegt wird, bis sie durch diese Bewegung in den Wendering 124 eingebracht ist. Hierbei ist ein Abstand zwischen der Auflageplatte 142 und dem Wendering 124, insbesondere zwischen der Auflagefläche 144 der Auflageplatte 142 und der Drehachse 128 des Wenderings 124, verstellbar eingerichtet.

Erfindungsgemäß wird das Brillenglas 152, so lange verschoben, bis der Schwerpunkt 154 des Brillenglases 152 in die Drehachse 128, um welche der Wendering 124 drehbar gelagert ist, gebracht ist. Damit wird das Brillenglas 152, derart in den Wendering 124 eingespannt, dass der Schwerpunkt 154 des Brillenglases 152 schließlich auf der Drehachse 128 des Wenderings 124 zu liegen kommt. Wie oben beschrieben, kann so ermöglicht werden, dass ein Wendevorgang des Wenderings 124 vollständig abgeschlossen werden kann, auch wenn ein Magnetfeld, das zum Wenden des Wenderings 124 aktiviert wurde, vorher abgeschaltet wurde. Während des Wendevorgangs kann der Wendering 124, der auf Segmente einer Kalotte der Vakuumbeschichtungsanlage aufgebracht ist, gewendet werden. Hierbei werden in der Regel nicht alle sich auf der Kalotte der Vakuum-Beschichtungsanlage befindlichen Wenderinge 124 gleichzeitig gewendet, sondern nacheinander innerhalb eines Kalotten-Kranzes. Der Wendevorgang erfolgt, wenn der Wendering 124 während einer Rotation der Kalotte an dem Magnetfeld vorbeigeführt wird. Wird hierbei der magnetisierbare Wendering 124 vom dem Magnetfeld angezogen, beginnt er, um die Drehachse des Wenderings zu rotieren, insbesondere um einen Winkel von ± 180°. Andere Arten der Ausgestaltung des Wendevorgangs sind jedoch möglich.

Erfindungsgemäß ist das Trägerelement ferner verschiebbar gegenüber der Auflage 150 gelagert. Dadurch wird die Verschiebung des Schwerpunkts 154 des Brillenglases 152 in die Drehachse 128, um welche der Wendering 124 drehbar gelagert ist, ermöglicht.

Besonders bevorzugt ist es, wenn das Trägerelement 136 stufenlos verschiebbar ist, und zwar gegenüber dem Trägerkörper 134 und gegenüber der Auflage 150.

Dadurch kann die Verschiebung einen beliebigen Wert innerhalb eines Intervalls, begrenzt aus einer minimalen Verschiebung und einer maximalen Verschiebung, einnehmen. Insbesondere bei der Einbringung von Brillengläsern 152 in den Wendering 124 kann ein Intervall von größer als 0 mm bis zu 30 mm, innerhalb dessen die Verschiebung, insbesondere die stufenlose Verschiebung, des Trägerelements 136 möglich ist, besonders bevorzugt sein. In einer alternativen, jedoch weniger bevorzugten Ausgestaltung kann das Trägerelement 136 inkrementell, d.h. in kleinen Schritten, verschiebbar sein.

Die Verschiebung, insbesondere die stufenlose Verschiebung, des Trägerelements 136 erfolgt mittels einer Verschiebeeinrichtung 160, welche dazu eingerichtet ist, um das Trägerelement 136 verschiebbar gegenüber dem Trägerkörper 134 zu lagern. Das in Figur 1 schematisch dargestellte Ausführungsbeispiel der Verschiebeeinrichtung 160 umfasst eine mechanische Einrichtung in Form einer Federeinrichtung 162, welche über mindestens eine Druckfeder 164 verfügt, die in einen eigens dafür vorgesehenen Federschaft 166 eingebracht ist. Wie Figur 1A zeigt, kann hierbei die Verschiebung der Auflageplatte 142 durch eine Federlagerung der Auflageplatte 142 auf den Druckfedern 164 ermöglicht werden. Alternativ kann anstelle einer mechanischen Federung auch eine andere Art der Federung eingesetzt werden (nicht dargestellt), insbesondere eine Federung mittels eines elastischen Materials, vorzugsweise unter Verwendung eines Schaumstoffs, eines Gummis oder eines Luftballs. Andere Arten von Verschiebeeinrichtungen sind jedoch denkbar; insbesondere eine Schraubeinrichtung oder eine hydraulische Einrichtung (nicht dargestellt).

Bei der Verschiebung des Trägerelements 136 auf die vorgeschlagene Weise kann in vorteilhafter Weise ausgenutzt werden, dass die Lage des Schwerpunkts 154 des Brillenglases 152 ausreichend gut mit der Form und des Gewichts des Brillenglases 152 korrelieren kann. Wie bereits erwähnt, kann die vorliegende Vorrichtung 110 somit bei dem Einbringen der Brillengläser 152 in den Wendering 124 eine Anpassung von vielfältigen Schwerpunktlagen unterschiedlicher Brillengläser 152 an die Lage der Drehachse 128 des Wenderings 124 durch das bevorzugt stufenlos höhenverschiebbare Trägerelement 136 erreicht werden.

Das in Figur 1 schematisch dargestellte Ausführungsbeispiel der Vorrichtung 110 kann ferner mindestens eine Führungseinrichtung 168 zur Führung des Trägerelements 136 aufweisen. Wie Figur 1A zeigt, kann die Führungseinrichtung 168 hierbei über mehrere zylindrische Führungsstangen 170 verfügen, welche in einem eigens dafür vorgesehenen Führungsschaft 172 derart führbar sind, dass sie in das Trägerelement 136 eingreifen können. Damit kann eine Verschiebung des Trägerelements 136 in die gewünschte Richtung 158 ohne ein Verkippen des Trägerelements 136 ermöglicht werden, vor allem um damit ein Abrutschen der Linse 112 von der Auflagefläche 144 der Auflageplatte 142 zu verhindern.

In einer besonders bevorzugten Ausführung kann die mindestens eine Druckfeder 164 und/oder die mindestens eine Führungsstange 170 in der Nähe eines Rands der Auflageplatte 142 angeordnet sein, vor allem um auf diese Weise eine möglichst stabile Lage des Trägerelements 136 zu erreichen. Hierbei kann ein Mittelpunkt einer Mittelsenkrechten der Druckfeder 164 und/oder der Führungsstange 170 weniger als ein Viertel eines Durchmessers der Auflageplatte 142 vom Rand entfernt angebracht sein. Eine andere Ausführung ist jedoch möglich.

Vorzugsweise kann die Auflagefläche 144 für die Linse 112, insbesondere für das Brillenglas 152, und/oder die Auflage 150 für den Wendering 124 gleitreibungsarm ausgeführt sein. Dadurch kann sich die Linse 112 und/oder der Wendering 124 beim Einspannen leicht bewegen lassen. Weiterhin können auch die Oberflächen der Federschäfte 166 und/oder der Führungsschäfte 172 der mindestens einen Druckfeder 164 bzw. der mindestens einen Führungsstange 170 derart ausgeführt sein, dass die mindestens eine Druckfeder 164 und/oder die mindestens eine Führungsstange 170 möglichst leicht beweglich sind. Wie bereits erwähnt, ist hierbei ein Reibungskoeffizient von 0,02 bis 0,5 für die Gleitreibung nach DIN 53375 besonders bevorzugt.

In einer besonderen Ausführung kann der Trägerkörper 134, insbesondere die Auflage 150, Bolzen 174 aufweisen, die zum Spreizen der Spannfedern 122 dienen können. Zum Spreizen der Spannfedern 122 kann der Wendering 124 bevorzugt im Uhrzeigersinn gedreht werden. Diese Bolzen 174 können hierbei gegenüber den Enden eines Sternteils 176 liegen, das als Teil der Auflageplatte 142 ausgeführt sein kann oder, bevorzugt, als separates Teil auf die Auflageplatte 142 gelegt werden kann. Hierbei kann eine laterale Abmessung der Bolzen 174 mindestens so groß sein wie eine größte laterale Ausdehnung eines Federteils der Spannfedern 122, welches beim Spreizen der Spannfedern 122 nicht an dem Bolzen 174 entlanggeführt wird. Auf diese Weise kann jede der Spannfedern 122, auch wenn deren Ende nach innen gebogen ist, weit genug von der Auflageplatte 142 entfernt sein, dass sich die Auflageplatte 142 möglichst ohne Hinderung bewegen kann.

Wie bereits erwähnt, wird die Lage des Schwerpunkts 154 des Brillenglases 152 bei der Auflage auf die Auflageplatte 142 durch dessen Form bestimmt. Aufgrund von zahlreichen unterschiedlichen Formen der Brillengläser 152 weisen deren Schwerpunkte 154, wie aus Figur 2 hervorgeht, einen entsprechend unterschiedlichen Abstand 178 von der Auflagefläche 144 auf. Die hier vorgeschlagene Einrichtung einer variable Höhe für die Auflagefläche 144 löst daher die Aufgabe der vorliegenden Erfindung, den Schwerpunkt 154 des Brillenglases 152 in die Drehachse 128 des Wenderings 124 zu bringen und unterscheidet sich hierdurch von Vorrichtungen, die aus dem Stand der Technik bekannt sind, welche über eine starre Auflagefläche verfügen.

Figur 3 zeigt schematisch ein Ablaufdiagramm 180 eines erfindungsgemäßen Ausführungsbeispiels eines Verfahrens zur Einbringung der optischen Linse 112 in die Wcndccinrichtung 114. Gemäß einem Bcrcitstcllungsschritt 182 wird die Vorrichtung 110 zur Einbringung der Linse 112 in die Wendeeinrichtung 114 in einem Ausgangszustand bereitgestellt. Gemäß einem Aufbringungsschritt 184 erfolgt ein Aufbringen der handzuhabenden Linse 112 auf das Trägerelement 136. Wie oben beschrieben, handelt es sich bei der Linse 112 besonders bevorzugt um ein Brillenglas 152. Vorzugsweise kann der Aufbringungsschritt 184 mittels einer automatischen Handhabungseinrichtung, beispielsweise mittels eines Roboters, durchgeführt werden. Gemäß einem Einbringungsschritt 186 erfolgt die Einbringung der Linse 112 von dem Trägerelement 136 in die Wendeeinrichtung 114 derart, dass hierbei das Trägerelement 136 so gegenüber dem Trägerkörper 134 verschoben wird, dass dadurch die Linse 112 in die Wendeeinrichtung 114 eingebracht wird. In der besonders bevorzugten Ausgestaltung nach Figur 1 wird die Wendeeinrichtung 114 auf die mindestens eine Auflage 150 gelegt und das Trägerelement 136 zusätzlich auch gegenüber der Auflage 150 verschoben. Besonders bevorzugt ist hierbei, wenn das Trägerelement 136 solange gegenüber dem Trägerkörper 134 verschoben wird, bis der Schwerpunkt 154 des Brillenglases 152 schließlich in die Drehachse 128, um welche die Wendeeinrichtung 114 drehbar gelagert ist, gebracht ist. Die hierein dargestellten Verfahrensschritte können vorzugsweise in einem Verfahren zur Herstellung mindestens eines Brillenglases 152 eingesetzt werden. Dieses Verfahren umfasst eine Handhabung des Brillenglases 152 zumindest während der Herstellung des Brillenglases 152 mittels des Verfahrens zur Einbringung der Linse 112 in die Wendeeinrichtung 114.

### Bezugszeichenliste

- 110: Vorrichtung
- 112: (optische) Linse
- 114: Wendeeinrichtung
- 116: Halterung
- 118: Rahmen
- 120: Haltemittel
- 122: Spannfeder
- 124: Wendering
- 126: Außenseite des Wenderings
- 128: Drehachse
- 130: Einrichtung
- 132: Stab
- 134: Trägerkörper
- 136: Trägerelement
- 138: Aussparung
- 140: Außenseite des Trägerkörpers
- 142: Auflageplatte
- 144: Auflagefläche
- 146: runde Auflagefläche
- 148: Spalt
- 150: Auflage
- 152: Brillenglas
- 154: Schwerpunkt
- 156: Volumen
- 158: Richtung
- 160: Verschiebeeinrichtung
- 162: Federeinrichtung
- 164: Druckfeder
- 166: Federschaft
- 168: Führungseinrichtung
- 170: Führungsstange
- 172: Führungsschaft
- 174: Bolzen
- 176: Sternteil
- 178: Abstand
- 180: Ablaufdiagramm
- 182: Bereitstellungsschritt
- 184: Aufbringungsschritt
- 186: Einbringungsschritt

## Patentansprüche

1. Wendeeinrichtung (114) und eine damit räumlich fixierte Vorrichtung (110) zur Einbringung einer optischen Linse (112) in die Wendeeinrichtung (114), wobei die optische Linse (112) einen Schwerpunkt (154) aufweist, wobei die Vorrichtung (110) einen Trägerkörper (134) und ein Trägerelement (136) zur Aufnahme der optischen Linse (112) umfasst, wobei der Trägerkörper (134) dazu eingerichtet ist, das Trägerelement (136) aufzunehmen, wobei das Trägerelement (136) eine Auflagefläche (144) zur Aufnahme der optischen Linse (112) aufweist, und wobei der Trägerkörper (134) weiterhin mindestens eine Auflage (150) für die Wendeeinrichtung (114) aufweist, wobei
das Trägerelement (136) verschiebbar gegenüber dem Trägerkörper (134) gelagert ist, das Trägerelement (136) ferner verschiebbar gegenüber der Auflage (150) gelagert ist,
**dadurch gekennzeichnet, dass**
die Vorrichtung (110) dazu eingerichtet ist, den Schwerpunkt (154) der optischen Linse (112) in eine Drehachse (128), um welche die Wendeeinrichtung (114) drehbar gelagert ist, einzubringen.

2. Wendeeinrichtung (114) und damit räumlich fixierte Vorrichtung (110) nach dem vorangehenden Anspruch, **dadurch gekennzeichnet, dass** das Trägerelement (136) stufenlos verschiebbar ist.

3. Wendeeinrichtung (114) und damit räumlich fixierte Vorrichtung (110) nach einem der vorangehenden Ansprüche, **dadurch gekennzeichnet, dass** das Trägerelement (136) in eine Aussparung (138) des Trägerkörpers (134) eingebracht ist.

4. Wendeeinrichtung (114) und damit räumlich fixierte Vorrichtung (110) nach einem der vorangehenden Ansprüche, **dadurch gekennzeichnet, dass** die Auflagefläche (144) ein Höhenprofil aufweist.

5. Wendeeinrichtung (114) und damit räumlich fixierte Vorrichtung (110) nach dem vorangehenden Anspruch, **dadurch gekennzeichnet, dass** das Höhenprofil einen Höhenunterschied von größer als 0 mm bis zu 10 mm aufweist.

6. Wendeeinrichtung (114) und damit räumlich fixierte Vorrichtung (110) nach einem der vorangehenden Ansprüche, **dadurch gekennzeichnet, dass** die Vorrichtung (110) weiterhin eine Verschiebeeinrichtung (160) zur Verschiebung des Trägerelements (136) gegenüber dem Trägerkörper (134) aufweist.

7. Wendeeinrichtung (114) und damit räumlich fixierte Vorrichtung (110) nach dem vorangehenden Anspruch, **dadurch gekennzeichnet, dass** die Verschiebeeinrichtung (160) ausgewählt ist aus einer Federeinrichtung (162), einer hydraulischen Einrichtung oder einer Schraubeinrichtung.

8. Wendeeinrichtung (114) und damit räumlich fixierte Vorrichtung (110) nach einem der vorangehenden Ansprüche, **dadurch gekennzeichnet, dass** die Vorrichtung (110) weiterhin mindestens eine Führungseinrichtung (168) zur Führung des Trägerelements (136) bei einer Verschiebung des Trägerelements (136) aufweist.

9. Wendeeinrichtung (114) und damit räumlich fixierte Vorrichtung (110) nach dem vorangehenden Anspruch, **dadurch gekennzeichnet, dass** die Führungseinrichtung (168) Führungsstangen (170) aufweist, wobei jede der Führungsstangen (170) derart in einem entsprechenden von dem Trägerkörper (134) umfassten Führungsschaft (172) führbar ist, dass sie in das Trägerelement (136) eingreift.

10. Verfahren zur Einbringung einer optischen Linse (112) in eine Wendeeinrichtung (114), umfassend die Schritte:
a) Bereitstellen einer Wendeeinrichtung (114) und einer damit räumlich fixierten Vorrichtung (110) zur Einbringung einer optischen Linse (112) in die Wendeeinrichtung (114), wobei die optische Linse (112) einen Schwerpunkt (154) aufweist, wobei die Vorrichtung (110) einen Trägerkörper (134) und ein Trägerelement (136) zur Aufnahme der optischen Linse (112) umfasst, wobei der Trägerkörper (134) dazu eingerichtet ist, das Trägerelement (136) aufzunehmen, und wobei das Trägerelement (136) eine Auflagefläche (144) zur Aufnahme der optischen Linse (112) aufweist, und wobei der Trägerkörper (134) mindestens eine Auflage (150) für die Wendeeinrichtung (114) aufweist;
b) Aufbringen der optischen Linse (112) auf das Trägerelement (136);
c) Einbringung der optischen Linse (112) von dem Trägerelement (136) in die Wendeeinrichtung (114),
wobei das Trägerelement (136) derart gegenüber dem Trägerkörper (134) verschoben wird, dass die optische Linse (112) in die Wendeeinrichtung (114) eingebracht wird, wobei die Wendeeinrichtung (114) auf die mindestens eine Auflage (150) gelegt wird und das Trägerelement (136) gegenüber der Auflage (150) verschoben wird,
**dadurch gekennzeichnet, dass**
der Schwerpunkt (154) der optischen Linse (112) in eine Drehachse (128) gebracht wird, um welche die Wendeeinrichtung (114) drehbar gelagert ist.

11. Verfahren nach dem vorangehenden Anspruch, **dadurch gekennzeichnet, dass** die optische Linse (112) in die als Wendering (124) vorliegende Wendeeinrichtung (114) eingebracht wird.

12. Verfahren nach einem der beiden vorangehenden Ansprüche, **dadurch gekennzeichnet, dass** die optische Linse (112) ein Brillenglas (152) ist, wobei eine Handhabung des Brillenglases (152) mittels der Vorrichtung (110) zur Einbringung einer optischen Linse (112) in die Wendeeinrichtung (114) erfolgt.

13. Verfahren nach dem vorangehenden Anspruch, **dadurch gekennzeichnet, dass** zwischen einer Beschichtung einer ersten Seite des Brillenglases (152) und einer Beschichtung einer zweiten Seite des Brillenglases (152) ein Wenden des Brillenglases (152) mittels der Wendeeinrichtung (114) erfolgt.

## Claims

1. Turning device (114) and an apparatus (110), spatially fixed therewith, for introducing an optical lens (112) into the turning device (114), wherein the optical lens (112) has a centre of gravity (154), wherein the apparatus (110) comprises a carrier body (134) and a carrier element (136) for receiving the optical lens (112), wherein the carrier body (134) is configured to receive the carrier element (136), wherein the carrier element (136) has a supporting surface (144) for receiving the optical lens (112), and wherein the carrier body (134) furthermore has at least one support (150) for the turning device (114), wherein the carrier element (136) is mounted displaceably in relation to the carrier body (134), the carrier element (136) further is mounted displaceably in relation to the support (150),
**characterized in that**
the apparatus (110) is configured to bring the centre of gravity (154) of the optical lens (112) in line with an axis of rotation (128), about which the turning device (114) is rotatably mounted.

2. Turning device (114) and apparatus (110), spatially fixed therewith, according to the preceding claim, **characterized in that** the carrier element (136) is continuously displaceable.

3. Turning device (114) and apparatus (110), spatially fixed therewith, according to either one of the preceding claims, **characterized in that** the carrier element (136) is introduced into a cutout (138) of the carrier body (134) .

4. Turning device (114) and apparatus (110), spatially fixed therewith, according to any one of the preceding claims, **characterized in that** the supporting surface (144) has a height profile.

5. Turning device (114) and apparatus (110), spatially fixed therewith, according to the preceding claim, **characterized in that** the height profile has a height difference of more than 0 mm and up to 10 mm.

6. Turning device (114) and apparatus (110), spatially fixed therewith, according to any one of the preceding claims, **characterized in that** the apparatus (110) furthermore comprises a displacement device (160) for displacing the carrier element (136) in relation to the carrier body (134).

7. Turning device (114) and apparatus (110), spatially fixed therewith, according to the preceding claim, **characterized in that** the displacement device (160) is selected from a spring device (162), a hydraulic device or a screwing device.

8. Turning device (114) and apparatus (110), spatially fixed therewith, according to any one of the preceding claims, **characterized in that** the apparatus (110) furthermore comprises at least one guiding device (168) for guiding the carrier element (136) when the carrier element (136) is displaced.

9. Turning device (114) and apparatus (110), spatially fixed therewith, according to the preceding claim, **characterized in that** the guiding device (168) comprises guiding rods (170), wherein each of the guiding rods (170) is guidable in a corresponding guiding shaft (172), surrounded by the carrier body (134), in such a way that it engages in the carrier element (136).

10. Method for introducing an optical lens (112) into a turning device (114), comprising the steps of:
a) providing a turning device (114) and an apparatus (110), spatially fixed therewith, for introducing an optical lens (112) into the turning device (114), wherein the optical lens (112) has a centre of gravity (154), wherein the apparatus (110) comprises a carrier body (134) and a carrier element (136) for receiving the optical lens (112), wherein the carrier body (134) is configured to receive the carrier element (136), and wherein the carrier element (136) has a supporting surface (144) for receiving the optical lens (112), and wherein the carrier body (134) has at least one support (150) for the turning device (114),
b) applying the optical lens (112) on the carrier element (136);
c) introducing the optical lens (112) into the turning device (114) from the carrier element (136),
wherein the carrier element (136) is displaced in relation to the carrier body (134) in such a way that the optical lens (112) is introduced into the turning device (114), wherein the turning device (114) is placed on the at least one support (150) and the carrier element (136) is displaced in relation to the support (150). **characterized in that**
the centre of gravity (154) of the optical lens (112) is brought in line with an axis of rotation (128), about which the turning device (114) is rotatably mounted.

11. Method according to the preceding claim, **characterized in that** the optical lens (112) is introduced into the turning device (114) present as a turning ring (124).

12. Method according to either of the two preceding claims, **characterized in that** the optical lens (112) is a spectacle lens (152), wherein handling of the spectacle lens (152) is implemented by means of the apparatus (110) for introducing an optical lens (112) into the turning device (114).

13. Method according to the preceding claim, **characterized in that** the spectacle lens (152) is turned by means of the turning device (114) between a coating of a first side of the spectacle lens (152) and a coating of a second side of the spectacle lens (152).

## Revendications

1. Appareil de retournement (114) et dispositif (110) fixé à celui-ci dans l'espace pour insérer une lentille optique (112) dans l'appareil de retournement (114), la lentille optique (112) présentant un centre de gravité (154), le dispositif (110) comprenant un corps de support (134) et un élément de support (136) pour recevoir la lentille optique (112), le corps de support (134) étant adapté pour recevoir l'élément de support (136), l'élément de support (136) présentant une surface d'appui (144) pour recevoir la lentille optique (112), et le corps de support (134) présentant en outre au moins un appui (150) pour l'appareil de retournement (114), l'élément de support (136) étant monté de manière à pouvoir être amené à coulisser par rapport au corps de support (134),
l'élément de support (136) étant en outre monté de manière à pouvoir être amené à coulisser par rapport à l'appui (150),
**caractérisé en ce que**
le dispositif (110) est adapté pour insérer le centre de gravité (154) de la lentille optique (112) dans un axe de rotation (128) autour duquel l'appareil de retournement (114) est monté de manière rotative.

2. Appareil de retournement (114) et dispositif (110) fixé à celui-ci dans l'espace selon la revendication précédente, **caractérisé en ce que** l'élément de support (136) peut être amené à coulisser en continu.

3. Appareil de retournement (114) et dispositif (110) fixé à celui-ci dans l'espace selon l'une quelconque des revendications précédentes, **caractérisé en ce que** l'élément de support (136) est inséré dans un évidement (138) du corps de support (134).

4. Appareil de retournement (114) et dispositif (110) fixé à celui-ci dans l'espace selon l'une quelconque des revendications précédentes, **caractérisé en ce que** la surface d'appui (144) présente un profil en hauteur.

5. Appareil de retournement (114) et dispositif (110) fixé à celui-ci dans l'espace selon la revendication précédente, **caractérisé en ce que** le profil en hauteur présente une différence de hauteur de plus de 0 mm à 10 mm.

6. Appareil de retournement (114) et dispositif (110) fixé à celui-ci dans l'espace selon l'une quelconque des revendications précédentes, **caractérisé en ce que** le dispositif (110) présente en outre un appareil de coulissement (160) pour amener l'élément de support (136) à coulisser par rapport au corps de support (134).

7. Appareil de retournement (114) et dispositif (110) fixé à celui-ci dans l'espace selon la revendication précédente, **caractérisé en ce que** l'appareil de coulissement (160) est choisi parmi un appareil à ressort (162), un appareil hydraulique ou un appareil à vis.

8. Appareil de retournement (114) et dispositif (110) fixé à celui-ci dans l'espace selon l'une quelconque des revendications précédentes, **caractérisé en ce que** le dispositif (110) présente en outre au moins un appareil de guidage (168) pour guider l'élément de support (136) lors d'un coulissement de l'élément de support (136).

9. Appareil de retournement (114) et dispositif (110) fixé à celui-ci dans l'espace selon la revendication précédente, **caractérisé en ce que** l'appareil de guidage (168) présente des tiges de guidage (170), chacune des tiges de guidage (170) pouvant être guidée dans un manchon de guidage correspondant (172) entouré par le corps de support (134), de telle sorte qu'elle s'engage dans l'élément de support (136).

10. Procédé pour insérer une lentille optique (112) dans un appareil de retournement (114), comprenant les étapes suivantes :
a) la fourniture d'un appareil de retournement (114) et d'un dispositif (110) fixé à celui-ci dans l'espace pour insérer une lentille optique (112) dans l'appareil de retournement (114), la lentille optique (112) présentant un centre de gravité (154), le dispositif (110) comprenant un corps de support (134) et un élément de support (136) pour recevoir la lentille optique (112), le corps de support (134) étant adapté pour recevoir l'élément de support (136), et l'élément de support (136) présentant une surface d'appui (144) pour recevoir la lentille optique (112), et le corps de support (134) présentant au moins un appui (150) pour l'appareil de retournement (114) ;
b) l'application de la lentille optique (112) sur l'élément de support (136) ;
c) l'insertion de la lentille optique (112) par l'élément de support (136) dans l'appareil de retournement (114),
l'élément de support (136) étant amené à coulisser par rapport au corps de support (134) de telle sorte que la lentille optique (112) est insérée dans l'appareil de retournement (114), l'appareil de retournement (114) étant placé sur l'au moins un appui (150) et l'élément de support (136) étant amené à coulisser par rapport à l'appui (150),
**caractérisé en ce que**
le centre de gravité (154) de la lentille optique (112) est mis dans un axe de rotation (128) autour duquel l'appareil de retournement (114) est monté de manière rotative.

11. Procédé selon la revendication précédente, **caractérisé en ce que** la lentille optique (112) est insérée dans l'appareil de retournement (114) se présentant sous forme d'anneau de retournement (124).

12. Procédé selon l'une quelconque des deux revendications précédentes, **caractérisé en ce que** la lentille optique (112) est un verre de lunettes (152), une manipulation du verre de lunettes (152) étant effectuée au moyen du dispositif (110) pour insérer une lentille optique (112) dans l'appareil de retournement (114) .

13. Procédé selon la revendication précédente, **caractérisé en ce qu'**entre un revêtement d'un premier côté du verre de lunettes (152) et un revêtement d'un deuxième côté du verre de lunettes (152), un retournement du verre de lunettes (152) est effectué au moyen de l'appareil de retournement (114).
